# EUROPEAN PATENT SPECIFICATION

(11) **EP 4 495 612 B1**
(45) Date of publication and mention of the grant of the patent: **25.11.2026**
(21) Application number: 23770257.6
(22) Date of filing: 16.02.2023
(51) Int. Cl.: G01R 31/367, G01R 31/382, G01R 31/385, H01M 10/48, H02J 7/00

(54) **REMAINING-BATTERY-CAPACITY ESTIMATION METHOD**
VERFAHREN ZUR SCHÄTZUNG DER VERBLEIBENDEN BATTERIEKAPAZITÄT
PROCÉDÉ D'ESTIMATION DE CAPACITÉ DE BATTERIE RESTANTE

(30) Priority: 17.03.2022 JP 2022043184
(43) Date of publication of application: 22.01.2025
(73) Proprietor: Toyota Motor Kyushu, Inc., Miyawaka-shi, Fukuoka 823-0015 (JP)
(72) Inventor: UCHIDA Hirokazu, Miyawaka-shi, Fukuoka 823-0015 (JP)
(74) Representative: Bandpay & Greuter
(86) International application number: PCT/JP2023/005571
(87) International publication number: WO 2023/176297

(56) References cited:
- CN-A- 112 255 559
- JP-A- 2022 015 085
- JP-A- 2022 015 085
- JP-A- H0 855 642
- JP-A- H09 329 654
- JP-B1- 7 090 949
- US-A1- 2018 031 642
- US-A1- 2019 353 711

## Description

### TECHNICAL FIELD

The present invention relates to a remaining-battery-capacity estimation method that can estimate a remaining-battery-capacity of a storage battery such as a nickel-metal hydride battery, a nickel-cadmium battery and a nickel-zinc battery and a rechargeable battery such as lithium secondary battery and an alkaline battery.

### BACKGROUND ART

Recently, there is an active restrictive movement to restrict an emission of carbon dioxide suspected to cause the global warming. Therefore, for example, as for cars, a drive system thereof gradually changes from a drive system using engines utilizing a fossil fuel such as a gasoline or a light oil to a drive system using a hybrid system or further motors utilizing a secondary battery capable of being repeatedly charged.

There is an active recycling movement such as a reuse of the secondary battery mentioned above. Due to the above situation, a battery information process system as one method to improve the estimation accuracy of a full charge capacity for, for example, modularized battery pack is proposed, (for example, see Patent Literature 1). This is a system to process the information on estimating the full charge capacity of the module. Such system has a memory device for storing neural network model already learned and an analysis device for estimating the full charge capacity of the secondary battery based on a measured result of an AC impedance of the module by utilizing the neural network model already learned.

Further, it is proposed that the neural network model already learned improves the estimation accuracy of the full charge capacity of the battery (for example, see Patent Literature 2). This neural network model is a model in which learning based on Nyquist plot of a plurality of modules, in which the full charge capacity of which lies within a reference range, is conducted. In this process system, a discriminant analysis is conducted by setting at least one future value extracted from Nyquist plot of the module as an explanatory variable. According to this, it is discriminated whether modules belong to the first group in which the full charge capacity lies within the reference range or belong to a second group in which the full charge capacity does not lie within the reference range. Further, in this system, for example, when it is discriminated that the module belongs to within the first group, the full charge capacity is estimated by utilizing the neural network model learned.

Further, for example, it is proposed that an estimation system for estimating with precision whether the battery capacity can be recovered by a capacity recovery process (for example, see Patent Literature 3). That is, in this system, in a case that the capacity recovery process is done for the module of a Nickel-metal hydride battery, it is discriminated whether the module belongs to the first group of which the battery capacity lowers than the reference capacity or the module belongs to the second group of which the battery capacity exceeds the reference capacity through M-T system (Maharanobis-Taguchi system) in which a plurality of explanatory variables is utilized. Specifically, the future value of the plural explanatory variables includes at least two AC impedance real number components plotted in a semicircular part, at least two AC impedance imaginary number components plotted in the semicircular part and at least one AC impedance imaginary number component plotted in a straight section.

Further, it is proposed that a control system of a secondary battery estimates other parameters (internal resistance, SOC: the state of charge, SOH: the state of health, and the like) with high precision, while conducting abnormality detection (for example, see Patent Literature 4). This control system detects the difference between a measured value (voltage) at some point and a voltage estimated by using pre-state variables. In this control system, a threshold voltage is set beforehand and an accidental abnormality, i.e., a micro short, is detected based on voltage difference. In this Patent Literature 4, further it is also described that it is preferrable to learn the chronological voltage difference data by using the neural network and to judge and detect whether normal or abnormal.

Other such art is found in PLT5.

### CITATION LIST

### PATENT LITERATURE

PLT1: Japanese Patent Application laid open No. 2020-20604,
PLT2: Japanese Patent Application laid open No. 2020-21592,
PLT3: Japanese Patent Application laid open No. 2020-24153,
PLT4: WO2019/138286
PLT5: US2018/031642A1.

### SUMMARY OF INVENTION

### TECHNICAL PROBLEM

The models or systems described in Patent Literatures use methods, for example, in which an internal resistance or a voltage value is measured and then a remaining-battery-capacity is estimated by a machine learning. However, the estimation accuracy of remaining-battery-capacity is not enough and it takes a long time when that the true value is measured.

According to the above situation, the purpose of the present invention is to provide a remaining-battery-capacity estimation method that can estimate a true value in a short period of time by utilizing a discharge measurement of the battery.

### SOLUTION TO PROBLEM

A first remaining-battery-capacity estimation method according to the present invention is a remaining-battery-capacity estimation method for estimating a remaining capacity of a battery which can be used repeatedly by charging, the estimation method comprising:
a defining step for defining a response variable for the remaining-battery-capacity estimation of the battery;
an extraction step for extracting a plurality of explanatory variables that have a high importance as an element that is used for estimating the remaining-battery-capacity and further have a linearity;
a derivation step for deriving a relational equation indicating the response variable and the explanatory variables as a regression equation;
an estimation step for conducting a time-course progress estimation of at least one of a discharge voltage value and a discharge current of the battery using the progression equation, and
an estimation step for estimating the remaining-battery-capacity.

The remaining-battery-capacity estimation method according to the present invention further uses a decreasing slope ([dV/dt] or [dA/dt]) relative to a whole measuring time of the discharge voltage or the discharge current discharge current, a decreasing rate per a unit of time within a specified time in a range excluding an initial value relative to at least any one of the discharge voltage value and the discharge current and the difference corresponding to the decreasing amount per a predetermined time interval for each explanatory variable.
In a second method, an initial voltage is used as a constant (intercept) in the regression equation.

According to the third remaining-battery-capacity estimation method of the present invention, a partial regression coefficient is calculated by regularizing each explanatory variable and the partial regression coefficient is used as each coefficient in each purpose variable in the regression equation.

According to the fourth remaining-battery-capacity estimation method according to the present invention, any one of the initial voltage values and the initial current value is included as a constant term in addition to the above plural explanatory variables.

### BRIEF DESCRIPTION OF DRAWINGS

Fig. 1 is a flowchart indicating a method when estimating a remaining-battery-capacity by using the remaining-battery-capacity estimation method according to one embodiment of the present invention.
Fig. 2A is a flowchart indicating a deriving method of a regression equation according to one embodiment of the present invention.
Fig. 2B is an explanatory view indicating a relation between explanatory variables and a purpose variable configuring the regression equation according to one embodiment of the present invention.
Fig. 3A is a graph indicating transient state of non-defective battery and defective battery becoming a target judged by the remaining-battery-capacity estimation method according to one embodiment of the present invention.
Fig. 3B is a demand graph used as a material to select the explanatory variables utilized in the remaining-battery-capacity estimation method according to one embodiment of the present invention.
Fig. 3C(A) is a graph indicating standard partial regression coefficient for the extracted explanatory variables becoming each element using in the remaining-battery-capacity estimation method according to one embodiment of the present invention.

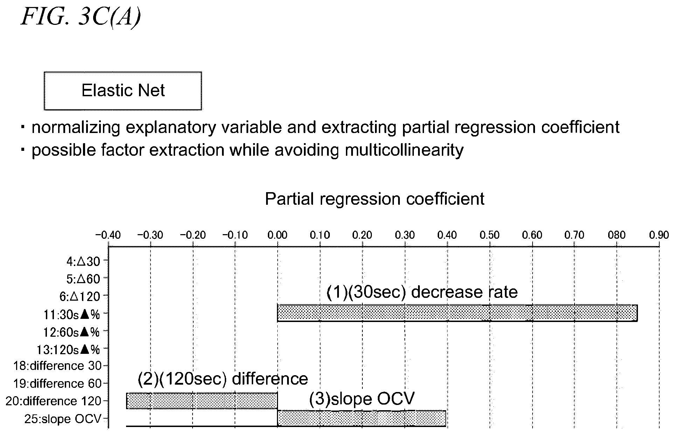

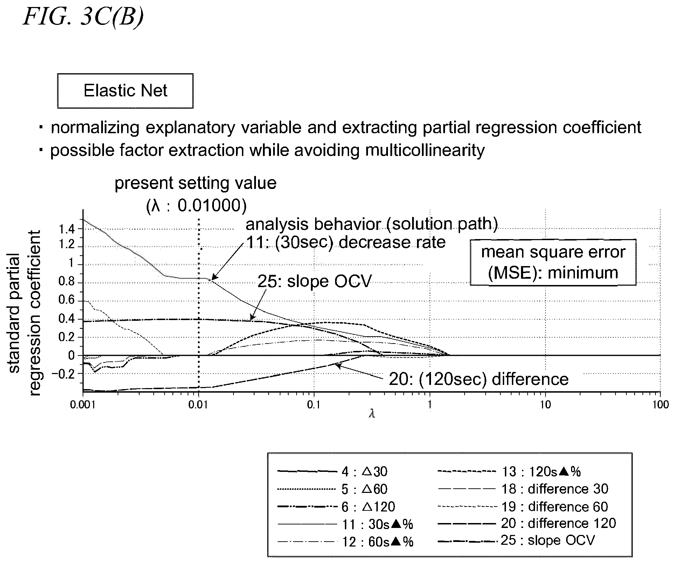

Fig. 3C(B) is a graph indicating an analysis behavior of each element as judgement materials to extract each element used in the remaining-battery-capacity estimation method according to one embodiment of the present invention.

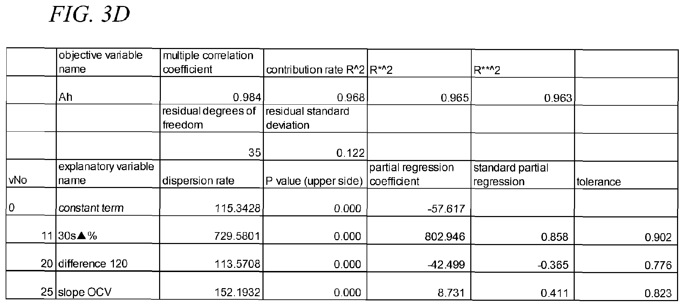

Fig. 3D is a table indicating data such as the partial regression coefficient used as material to select the explanatory variables used in the remaining-battery-capacity estimation method according to one embodiment of the present invention.

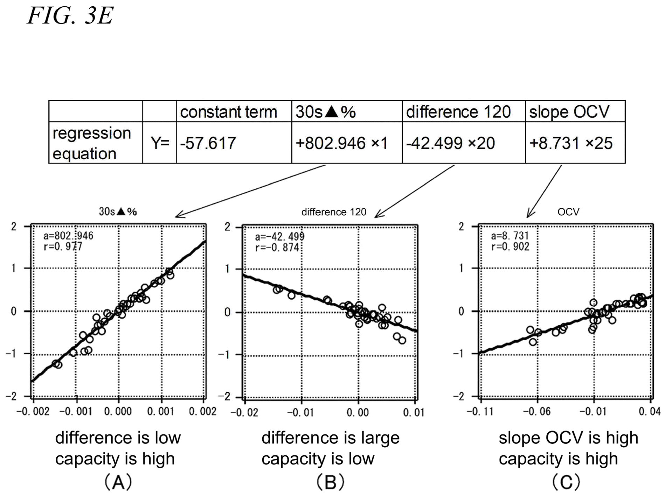

Fig. 3E is each graph indicating the explanatory variables in the regression equation used in the remaining-battery-capacity estimation method according to one embodiment of the present invention and the data used for calculating the coefficients are plotted.

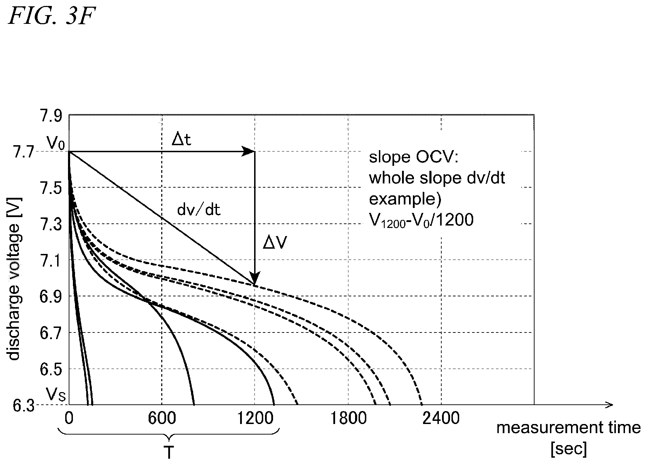

Fig. 3F is an explanatory view indicating whole slope within the explanatory variables in the regression equation used in the remaining-battery-capacity estimation method according to one embodiment of the present invention.

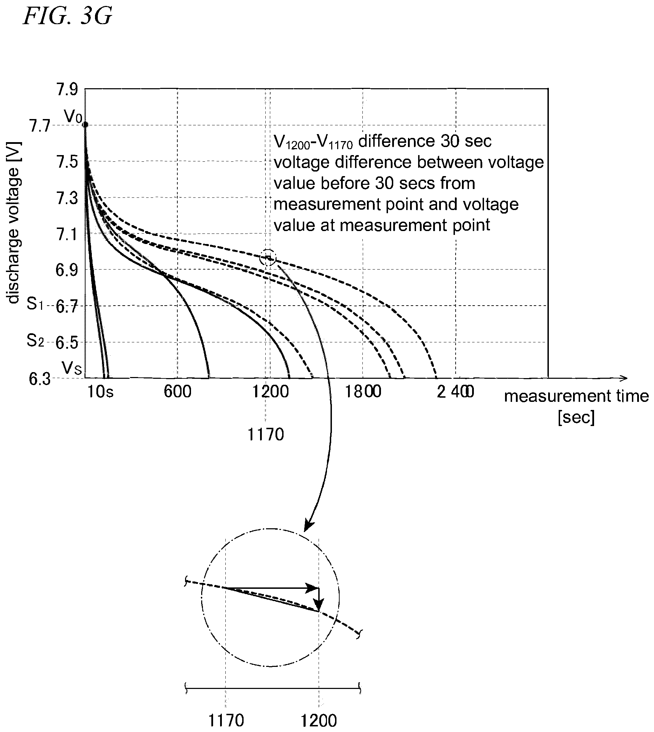

Fig. 3G is an explanatory view indicating difference in the explanatory variables in the regression equation used in the remaining-battery-capacity estimation method according to one embodiment of the present invention.

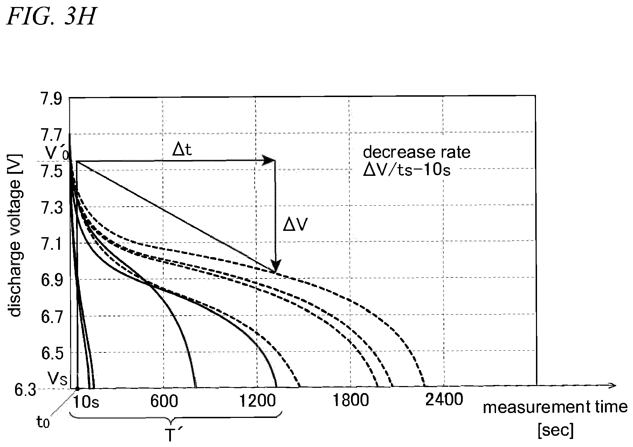

Fig. 3H is an explanatory view indicating decrease rate in the explanatory variables in the regression equation used in the remaining-battery-capacity estimation method according to one embodiment of the present invention.

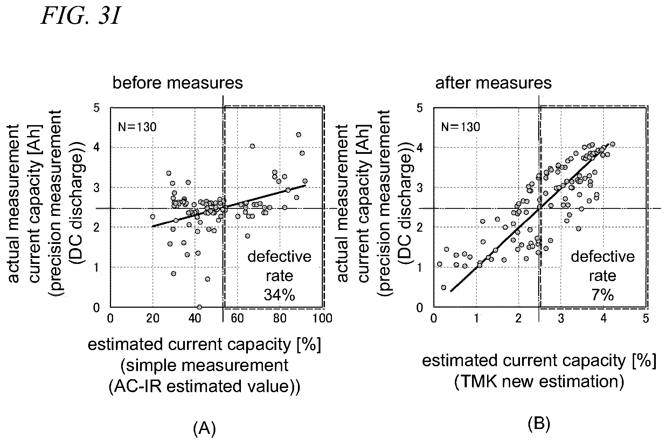

Fig 3I is an explanatory view indicating change of a defect rate before and after the remaining-battery-capacity estimation method is used according to one embodiment of the present invention.

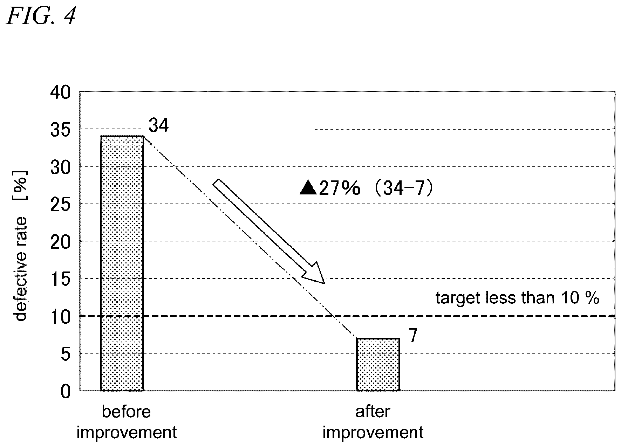

Fig. 4 is a graph indicating that the defect rate decreases to lower than 10% by using the remaining-battery-capacity estimation method according to one embodiment of the present invention.

### DESCRIPTION OF EMBODIMENTS

Hereinafter, it will be described in detail one embodiment and example (concrete example) according to the present invention with referring to attached drawings.

### <1. one embodiment>

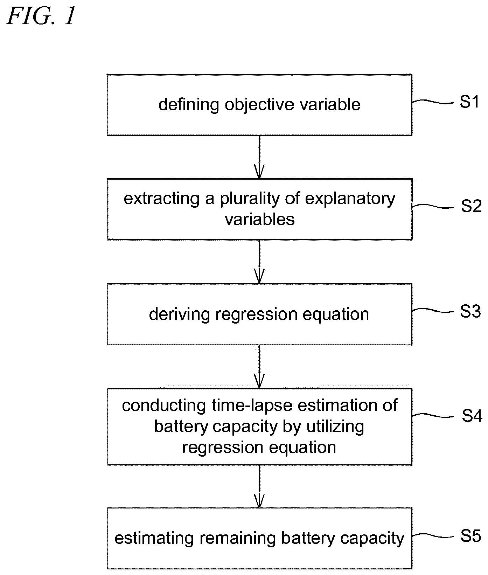

Fig. 1 is a method to conduct the remaining-battery-capacity estimation method including necessary steps to execute the remaining-battery-capacity estimation method according to one embodiment of the present invention. Here, in the present embodiment, as the battery to estimate the remaining-battery-capacity, it is intended for use of the battery of HEV (Hybrid-Electric Vehicle: Hybrid Car) (hereinafter, this is abbreviated as "battery"). However, the battery intended for use in the remaining-battery-capacity estimation method of the present invention is not of course limited to this. That is, the estimation method of the embodiment can be corresponded to various batteries such as a storage battery, a s nickel-metal hydride battery (NiH), a nickel-cadmium battery, a nickel-zinc battery and a lithium secondary battery and a rechargeable alkaline battery, which can be used repeatedly by charging.

### [Configuration steps of remaining-battery-capacity estimation method]

In the remaining-battery-capacity estimation method according to the present embodiment, as shown in Fig. 1, this method is configured to have the first step S1 ~ the fifth step S5, and the remaining capacity estimation is conducted by using the regression equation mentioned later.

In the embodiment mentioned later, [explanatory variable] and [objective variable or response variable] are used in the remaining-battery-capacity estimation method of the present invention. Here, as for technical terms, each variable can be respectively regarded as synonyms of [explanatory factor] and [response factor]. However, in mathematical concepts, a [factor] is each constituent element expressed by product format in one [term], thus is a general concept. On the other hand, in the present invention, a functional form in the regression equation mentioned later is a polynomial form and, considering that these correspond to and are equivalent with each [explanatory variable] and each [term], designation such as a [factor] is avoided and a [variable] in the former technical term is used.

A general flow of the regression analysis according to one embodiment of the present invention will be explained hereinbelow by using Fig. 1. However, here a method to determine the regression equation will be explained first.

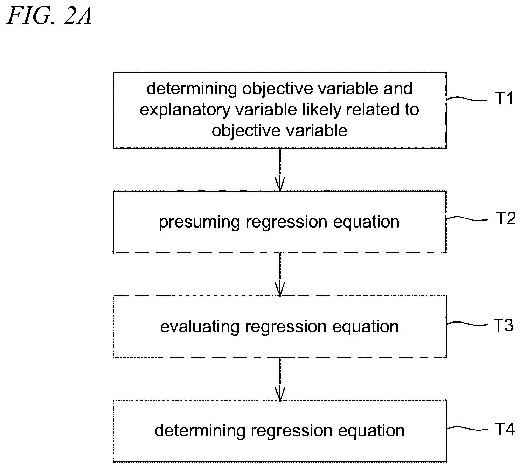

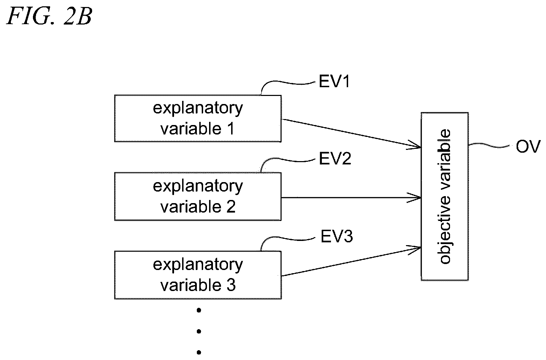

Here, in one embodiment of the present invention, in order to implement the method for estimating the remaining battery capacity, the [regression analysis] technique is used. As for a general technique to obtain a [regression equation] used for the regression analysis, it will be described in detail while suitably referring to Fig. 2. Incidentally, in this regression analysis, since a plurality of elements shown in Fig. 2B is used especially here as the explanatory variables, it is configured to conduct a [multiple regression analysis].

That is, in this multiple regression analysis, the dependent variable corresponding to the response variable is estimated and explained by using independent variables corresponding to the plural explanatory variables.

This multiple regression analysis is configured from the following first step T1 to the fourth step T4 as shown in Fig. 2A as a general idea. Thereby, a suitable regression equation is determined.

In the first step T1, the objective variable (OV) and the explanatory variables (EV) were related with the objective variable are determined. In this regression analysis, a degree of impact given to the objective variable by the explanatory variables is quantifiable and such relation is expressed by an equation such as a straight line. Here, two kinds of intrinsic variables, that is, the relationship between the explanatory variables (EV1, EV2, ...) and the objective variable (OV) is indicated in Fig. 2B.

Here, in the present embodiment, although Elastic Net regression is used to determine the explanatory variables as elements from the data obtained beforehand, this will be described later.

In second step T2, the regression equation is presumed. This regression equation means the equation obtained as the result of the regression analysis. Concretely, the regression equation is functional as shown in the equation (1) mentioned later. This regression equation is obtained by putting together into one equation of the relation between the objective variable and the explanatory variables by estimating a [coefficient] value and a [intercept] value in the equation. The detailed description will be done hereinafter. Here, there may be called the coefficient here as the [regression coefficient].

Further, the coefficient in the multiple regression equation mentioned later may be called a [partial regression coefficient]. This partial regression coefficient is a coefficient depending on the size of the explanatory variable and the unit. Thus, it does not make sense if the coefficient of each explanatory variable is mutually compared. In order to mutually compare these coefficients, these coefficients are standardized by a method such as standard deviation regression, thereby the [standard partial regression coefficient] is obtained. According to the standard partial regression coefficient, in a case that the size or the unit of the explanatory variable is mutually different, the relative size of the coefficient can be compared. Therefore, an impact given to the objective variable can be mutually compared (see Fig. 3D).

Further, according to this regression analysis, the coefficient of the explanatory variable becoming an element (that is, regression coefficient) and the constant term (that is, intercept) can be determined based on the data obtained beforehand and the like. As for the coefficient and the intercept, for example, by using an OLS (Ordinary Least Squares), [partial regression coefficient] and a [regression constant (or may be called simply [constant])] can be respectively obtained so that the sum of squares of error of actual measurement and the predicted value of the dependent variable (obj ective variable) becomes smallest.

In the third step T3, the regression equation obtained (presumed) in the step T2 is evaluated. As an index that is an evaluation standard, a precision of the regression equation (amendment value R2), a coefficient (P value), a statistical significance (that is, significance of the regression equation: significant value F), or an impact (t value) and the like.

Here, in the multiple regression analysis, each coefficient of the explanatory variable in the regression equation may be called as a [partial regression coefficient]. Here, although respective definition will be omitted, [amendment value R2] lies within a range of 0 ~ 1 and the regression equation is judged with a high precision when the amendment value R2 is closer to 1.
- In a case that the [P value] is less than 0.5. it can be judged that the explanatory variable has a high relationship with the objective variable.
- In a case that the [F value] is less than 0.5, it can be judged that the regression equation is significant.
- The [t value] has a strong impact if an absolute value thereof is larger and as a rule of thumb, if the t value is less than 2, it is judged that the explanatory variable does not affect the objective variable.

Here, as the method to evaluate the regression equation, in addition to the method calculating determination coefficient in the multiple regression analysis, there is a [residual analysis] to see the variation in the residuals and if the regression equation is valid for actual measurements, it is known that residuals varied appropriately (dispersion uniformity). Thus, to check this, for example, a graph of the [residual plot] in which residuals of each data are arranged in order and a manual verification is conducted (in this graph, for example, the data number can be set on the abscissa and the value of residual can be set on the vertical axis). Here, in the residual plot, it is confirmed how the residual on the abscissa side is varied relative to [0] on the vertical axis. Here, if the residual is uniformly dispersed relative to [0] on the vertical axis, there is no big problem.

In the fourth step T4, the regression equations obtained in the third step T3 are evaluated and the regression equation with the high evaluation such as a precision is determined. This is used as the regression equation in the remaining-battery-capacity estimation method.

### [Remaining capacity estimation method]

Next, it will be described about the method to estimate the remaining battery capacity including steps necessary for executing the remaining battery capacity estimation method according to one embodiment of the present invention. In this remaining capacity estimation method, as shown in Fig. 1, it is configured from the first step S1 to the fifth step S5.

In the first step S1, the [objective variable] is defined by putting together in one equation [plural explanatory variables] and the [constant] in the equation (1) mentioned later (as for these elements, it will be detained in the second step S2 in detail), thus this is defined as the [objective variable]. Here, the [objective variable] is a variable that is a result occurring due to a cause that is a target in the [explanatory variable].

In the second step S2, a plurality of [explanatory variables: EV] are extracted. Here, the [explanatory variable: EV] is also called as an [independent variable] and refers to a variable that is a cause of something. In the present invention, as for the [explanatory variables], as shown in Fig.3C(B), the [explanatory variables] with high Cross-validation result of the Elastic Net regression and with stable analysis behavior is extracted. That is, in the present embodiment, as for details, although definition thereof will be described later in the example, as shown in Fig.3C(A), three elements of
- (30 sec) decrease rate
- (120 sec) difference
- whole slope S (slope OCV)
are extracted as the explanatory variable.

Here, as for each of these elements, it is necessary and important to select with high linearity as necessary to define with the objective variable mentioned later, in other words, as it is necessary that the principle of superposition becomes applicable. Here, [Elastic Net] is a technique synthesizing [ridge regression] and [LASSO]. In the Elastic Net, similar to [LASSO (lest angle regression)], by generating the coefficient of zero value, it can be generated a model with dimensionality reduction. According to empirical research, the Elastic Net technique data has predictors with a high relativity, so that the performance thereof is higher than LASSO. Further, the [cross validation result] is a technique to evaluate generalization performance of each model.

In the present embodiment, by using this [Elastic Net] technique, [normalization] challenges can be accurately solved in comparison with the other techniques. That is, a partial regression coefficient can be accurately calculated. Explaining mathematical definition of Elastic Net, relative to the next equation Z (being subject) described by using norm α defined strictly between 0 and 1 and a non-negative normalization parameter λ, the Elastic Net is a technique to give the solution. $Z ≡ min \left[\left(1/2N\right){{Σ}^{N}}_{i = 1}{\left({y}_{i}-{β}_{0}-{{x}_{i}}^{T}β\right)}^{2}+{λP}_{α}\left(β\right)\right]$

Here, N: measurement number
yᵢ: response data of measured value i
xᵢ: data (vector of P value of measured value i, xᵢ^{T} is tensor
λ: positive hyper parameter corresponding to one value of lambda
(for example, coefficient representing an impact of the normalization term)
β₀: scalar
β: vector
α: hyper parameter adjusts relative contribution of L1 norm (Manhattan distance) and L2 norm (Euclid distance) and the definition range is 0≤α≤1.
P_{α}(β): penalty term (normalization term)

Here, as for a penalty term (normalization term) P_{α}(β), although mathematical definition will be omitted as to specific details, the penalty term value can be obtained by using norm concerning β. By the way, in case of α=1, Elastic Net is the same as the LASSO. On the other hand, following that α shrinks toward 0, Elastic Net approaches to the ridge regression. Here, this [ridge regression] is a method to estimate the coefficient of the multiple regression model in case that the independent variable is strongly related. Further, this ridge regression is to resolve that an estimation of least squares becomes incorrect in case that the linear regression model has multicollinearity (in a case that independent variable strongly related exists) and the ridge regression estimation amount has higher accuracy than the estimation of least squares.

Further, if the coefficient of the normalization term becomes too large, a graph drawn according to the normalization term performs jumping behavior (penalty occurs), thus the normalization term is introduced as a parameter to adjust how effective the penalty is.

### [about explanatory variable]

For each explanatory variable of the present embodiment, it is necessary to extract linear functions because the obj ective variable is configured by combining various plural explanatory variables. Thus, among explanatory variables (mentioned later) selected as a big element predicted as the configuring causes, next three elements ware extracted as elements which are important and have linearity, especially elements importantly influence to the objective variable.

That is,
1) The [whole slope (=dv/dt)] is a time slope as aa whole of the [initial voltage or Open Circuit Voltage (OCV): rest potential] and this [whole slope S] may be called as a [slope OCV]. That is, it is a defined voltage change rate over whole time till special measuring time range from initial time (t=0) giving the (initial voltage or) Open Voltage Circuit (OCV), that is, a voltage change rate over the whole time interval till the special measuring time range, that is, the voltage slope for all time. Further, this is defined by the [first explanatory variable: x1].
2) [difference]
   This is defined by the [second explanatory variable:x2].
3) [decrease rate] (=dv'/dt')]
   This is defined by the [third explanatory variable:x3].

Here, although details will be described later, the objective variable y obtained by using these explanatory variables x, that is, the regression equation can be expressed as the next equation (1). $y = \left[\left(k1\right)\cdot \left(x1\right)\right] + \left[\left(k2\right)\cdot \left(x2\right)\right] + \left.\left(k3\right)\cdot \left(x3\right)\right] + c$ (1)

Here, x1, x2, x3: explanatory variables
k1, k2, k3: coefficients
c: constant (intercept)

Here, generally, it is necessary to remove an explanatory variable having multicollinearity between explanatory variables extracted in the above. Here, (multi)collinearity means that a linear relevance exists between two explanatory variables, in other words, in the multiple regression model, a combination of the high correlation coefficients will exist between explanatory variables.

Here, as for the method to extract the explanatory variables that is the element thereof, for example, the element of the explanatory variable is determined by a multiple regression analysis and in addition, a commentary of the obtained regression equation (regression model) is conducted. Further, as the development of the multiple regression analysis, the normalization (Lasso regression) is performed and in addition, accuracy of the regression equation can also increase, so that such a normalization is the important technique. That is, this [normalization regression], for example, described in the above, is a technique that factors with strong multicollinearity are wholly multiplied by the coefficient and the feature representation can be conducted as the partial regression coefficient. Thus, due to the whole multiplying by the coefficient, a tugging each other occurs, as a result, coefficient reduction of the regression equation occurs (that's why normalization regression is called as a reduced estimation). Therefore, although the detailed description will be omitted here, based on knowledge obtained from years of knowledge and experience of the inventor of the present application, in the present embodiment, the multiple regression analysis is again conducted after the explanatory variables are once derived and a technique to return to the regression equation without reduction is conducted.

For example, as the technique to obtain this regression equation, in the present embodiment, as described by using Fig. 2A, the method configured from the first step T1 ~ the fourth step T4 is used.

Here, the purpose to execute this multiple regression analysis is to estimate and explain the objective variable ([y] in the regression equation mentioned later) by using the dependent variables ([x] in the regression equation mentioned later). Estimation power and explanatory power of the explanatory variables can be regarded as a magnitude of influence of the explanatory variables for the objective variable. Thus, the partial regression coefficient and the regression constant mentioned in the above can be obtained by using least squares (OLS) so that the sum of squares of error of actually measured value and predicted value of the objective variable becomes minimum.

### (i) [whole slope S]: the first explanatory variable

That is, the whole slope S (slope OCV) (=dv/dt) is, as shown in Fig. 3F, defined by the whole slope (over whole of timeline) in the graph concerning the measurement time [sec] for the discharge voltage [V]. Mathematically, the whole slope becomes linear functions.

Here, for example as shown in Fig.3F, the [whole] indicates the transition of the discharge voltage [V] during the special time range T to the special time t_{S} when the discharge voltage V drops from the discharge voltage V₀ at the initial time t₀ to the special value V_{S} (hereinafter, this value is called as the [lowest effective discharge voltage V_{S}]).

In the battery used in the present embodiment, if the special time Δt is set (specified), the temporal transition (change) about the descent phenomenon of discharge voltage is unambiguously determined within the special time. That is, descent curve (hereinafter, it may be called as [descent function] of discharge voltage) within the special time can be uniquely drawn (determined). As mentioned, in a case that descent curve of the discharge voltage can be uniquely drawn (determined), as for the mentioned whole slope S (=dv/dt), the whole slope within the special time range T is determined linear functions, even if the special time T is how far set and the descent function is what kind of functional form (descent curve). In other words, based on the discharge voltage V₀ at the initial time, that is, discharge start time (t=0), the special time range T and the discharge voltage value V_{S} after the special time range T is elapsed to the end, the whole slope S (=dv/dt) is uniquely determined. That is, $\begin{matrix}S = dv / dt \\ = \left({V}_{0}-{V}_{S}\right) / T\end{matrix}$ (2)

### (ii) [deference D]: second explanatory variable

This deference D is joined as the explanatory variables, according to following reason.

That is, the inventor of the present application ascertained that in a graph measuring time lapse of the discharge voltage, the element indicating amount of reduction per a predetermined time (for example, the necessary number of seconds every time) becomes a large contributing factor in the estimation of the remaining battery capacity, especially, the important element in the nickel metal hydride battery (NiH) and the like.

Here, in the present embodiment, for example, the data of voltage value (Vₘₑₛ) at the measurement time (this may be called as the [measurement point]) and the voltage value (Vₘₑₛ-30) at the measurement time before 30 seconds from the measurement point is used. That is, $D = \left({V}_{mes}-30\right) - \left({V}_{mes}\right)$ (3)

### (iii) [decrease percentage]: third explanatory variable

As for this [decrease rate (=dv'/dt')], temporally transition (change) for descent phenomenon of discharge voltage is uniquely determined for each individual battery for the whole of the time range T' (= T-t₀) effective for an estimation sampling. Here, for example, as shown in Fig. 3H, T' remains after removing unique time (this is called as the [initial time t₀]) from the discharge start time, that is, initial time (t=0).

That is, also in the decrease rate (=dv'/dt'), similarly to the case of the whole slope S, a descent curve (descent function) of the discharge voltage within the time range T' is uniquely drawn (determined). As mentioned, when the descent curve of the discharge voltage (descent function) is uniquely drawn (determined), similar to the case of the whole slope S (=dv/dt) which is the first element, even if in the decrease rate (= dv'/dt') which is the second element, the time range is no matter how far and the descent function is what kind of the functional form (descent curve), the whole slope within the time range T' is determined linear function. In other words, based on charge and discharge voltage V within the special time range T' in an arbitrary range obtained by only deducting the special initial time t₀ from the initial time and the special time range T' (=T-t₀), the decrease rate of the third element is uniquely determined. That is, $\begin{matrix}decrease rate = dv ′ / dt ′ \\ = \left({V}_{0}-{V}_{0}′-{V}_{S}\right) / \left(T-T′\right)\end{matrix}$ (4)

Here, it may be necessary to remove the initial time t₀ from the decrease rate which is the second element to conduct the accurate remaining capacity estimation since the voltage decrease is remarkable for 10 seconds from the discharge start in comparison with the later time and it is not preferable to use in the remaining capacity estimation.

Although three elements used in explanatory variables are described, the constant c is used besides this. Here, in the present embodiment, although three elements are configured as the explanatory variables, the whole slope, the difference and the decrease rate can be used, according to a kind of battery used as target for the remaining capacity estimation, it is not necessary to limit to the above explanatory variables. It is of course that, in a case that the better remaining estimation can be conducted, its explanatory variables may be adopted.

In the third step S3, the regression equation is derived. In the regression equation, as mentioned in the above, the explanatory variables giving a big impact to the objective variable are used and elements with linearity are used as the explanatory variables, further elements summing up these are defined as the objective variable.

That is, when a linearity of each explanatory variable (x1, x2, x3, • • •, xn) is utilized and the objective variable y in which the explanatory variables are summed up is defined, the following equation (regression equation) is established. $y ≡ \left[\left(k1\right)\cdot \left(x1\right)\right] + \left[\left(k2\right)\cdot \left(x2\right)\right] + \left[\left(k3\right)\cdot \left(x3\right)\right] \cdot \cdot \cdot + \left[\left(kn\right)\cdot \left(xn\right)\right] + c$

Here, x1, x2, x3, • • •, xn: explanatory variable
k1, k2, k3, • • •, kn: coefficient
c: constant (intercept)

Here, in the present embodiment, since the explanatory variables are three, the equation (regression equation) in the present embodiment becomes the following equation mentioned in the above. $y = \left[\left(k1\right)\cdot \left(x1\right)\right] + \left[\left(k2\right)\cdot \left(x2\right)\right] + \left[\left(k3\right)\cdot \left(x3\right)\right] + c$

Here, x1, x2, x3: explanatory variable
k1, k2, k3: coefficient
c: constant (intercept)

Here, in this regression equation (1), as mentioned in the above, it is requested to derive the equation with a high accuracy, thus evaluation of the estimated regression equation is conducted in advance and the regression equation with a high accuracy is selected. Here, although the selection method of the regression equation is already described with reference to Fig. 2, an explanation thereof will be omitted here. Further, a specific example thereof will be described in the example mentioned later.

In the fourth step S4, a time-lapse forecasting will be conducted for the remaining battery capacity by using the regression equation. As for the time-lapse forecasting, for example, in each nickel metal hydride (NiH) battery with rated voltage 8V, the current capacity is forecasted by a discharge for each nickel metal hydride (NiH) battery by using the regression equation (1) obtained in Step S3.

That is, in the present embodiment, voltage values of the battery capacity are monitored, for example, by giving constant current for about 3 minutes for each nickel metal hydride (NiH) battery whileconducting DC discharge for about 3 minutes. Further, by using voltage value obtained at that time, a transient of the remaining capacity for about 3 minute is detected for each nickel metal hydride battery. Thereby, various data are obtained, and the time-lapse forecasting of the subsequent remaining capacity can be conducted using the regression equation (1).

In the fifth step S5, based on that the time-lapse forecasting of the remaining capacity of each nickel metal hydride (NiH) battery by using the regression equation in the fourth step S4, a usable time till the voltage deceases within a range of effective voltage of each nickel metal hydride (NiH) battery is estimated, thereby quality as nickel metal hydride (NiH) battery is judged.

### [effect]

Therefore, conventionally when quality of the battery is judged, an AC-IR method measuring the internal resistance is used in selection of the battery and according to this method, for example, it took a great deal of measuring time to decrease the defect rate to the constant level in the quality selection process. That is, in case of short time measurement, an accuracy of quality estimation judgement is low, so that, many defectives are mixed therein as a result.

On the other hand, according to the present embodiment of the present invention, the regression equation (1) is selected so that it was found that a waveform graph (function) preferrable to estimate the remaining battery capacity by conducting current discharge for about 2 minutes (120 seconds) ~ 3 minutes (180 seconds) by using the regression equation (1). Therefore, as a result, it leads to a rapid selection of the battery repeatable as the secondary battery and an effective use thereof. Further, it can be brought in a progress of carbon neutrality.

### [One example of execution (concrete example)]

Next, hereinafter, it will be described that the method conducting remaining battery capacity estimation by executing the remaining battery capacity estimation method is explained in the embodiment according to the present invention. Here, it will be described in detail that the one example (concrete example) actually is implemented.

According to the present example, although details will be described later, it could be obtained that the regression equation is preferable to estimate time-lapse forecasting of the battery capacity of the nickel metal hydride (NiH) battery by using the remaining capacity estimation method of one previous embodiment. Hereafter, this will be described in detail.

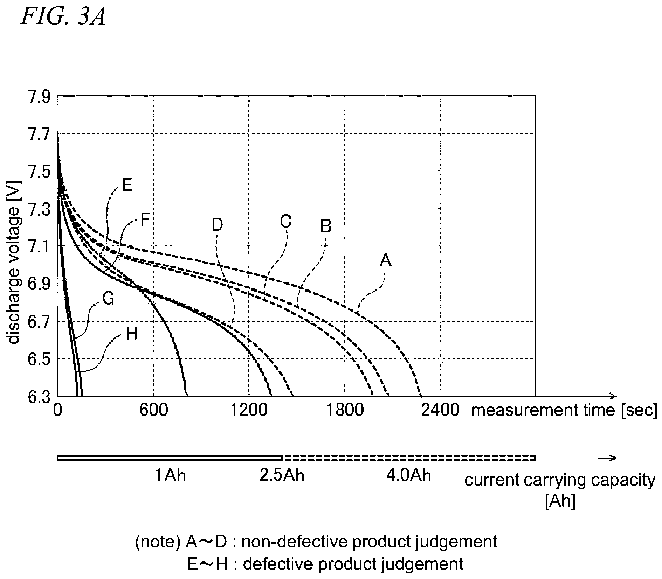

In the present example, when the explanatory variable is presumed, DC (direct current) discharge is conducted. Thereby, in the transient state in which the voltage (V) value of the nickel metal hydride (NiH) battery decreases from the rated voltage 8V to the current capacity value (for example, more than 6.3Ah) that is necessary for an actual use, graphs with non-defective product judgement satisfying the above conditions are indicated by signs A ~ D in Fig. 3A. On the other hand, graphs with defective product judgement are indicated by signs E ~ H.

### [Derivation of the regression equation]

Next, the explanatory variables are obtained by using a waveform graph of sign A ~ D indicating non-defective product. In this case, as for the derivation method of the explanatory variables, as mentioned, for example, it may be one method to extract the explanatory variables with high cross-validation results through R/F (random forest). Further, a method such as K-split cross-validation, can be used. Further, when these explanatory variables are derived, it is necessary and important to select the explanatory variables with a high linearity as necessary to derive with the obj ective variable. Here, in the present invention, especially when these explanatory variables are presumed and derived, various methods can be adopted without being limited to the above methods and techniques. For example, as correct presumption method, although it is concretely described hereinafter, Elastic Net and the like can be used.

That is, in the present example, a plurality of explanatory variables is presumed and derived through the Elastic Net method and the regression equation (1) as the previous one embodiment is obtained by using the derived explanatory variables and the constant.

For example, as described in one embodiment, that is, as described in the third step S3, by using a linearity of each explanatory variable (x1, x2, x3 • • •, xn), the objective variable obtained by summing up these explanatory variables is defined by y. Here, the following equation is established. $y ≡ \left[\left(k1\right)\cdot \left(x1\right)\right] + \left[\left(k2\right)\cdot \left(x2\right)\right] + \left[\left(k3\right)\cdot \left(x3\right)\right] \cdot \cdot \cdot + \left[\left(kn\right)\cdot \left(xn\right)\right] + c$

Here, k1, k2, k3, • • •, kn: coefficient
c: constant (intercept)

Here, in the present example, the explanatory variables are three. Thus, the equation in the present embodiment is as follows. $y = \left[\left(k1\right)\cdot \left(x1\right)\right] + \left[\left(k2\right)\cdot \left(x2\right)\right] + \left[\left(k3\right)\cdot \left(x3\right)\right] + c$

Here, x1, x2, x3: explanatory variable
k1, k2, k3: coefficient
c: constant (intercept)

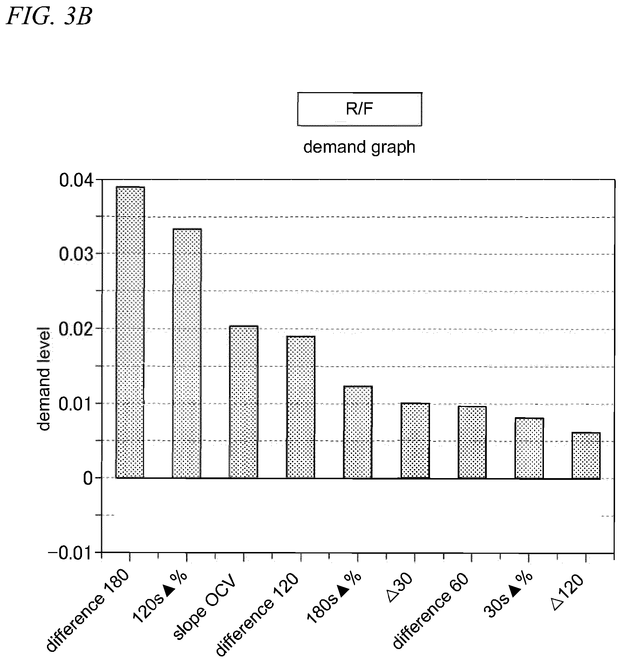

Here, if the explanatory variables with the high cross-validation results are temporarily extracted, for example, in the present example, based on the demand graph shown in Fig. 3B, such as a difference 180, 120s▲%, a whole slope OCV, a difference 120, 180s A%, △30, and a difference 60, 30s▲%, △120 contribute to the demand in order. However, in this forecasting method, among elements with a high contribution for demand, the whole slope OCV and the difference 120 are preferable to be adopted as the explanatory variables. However, the other elements with a high contribution for the demand, that is, the difference 180, 120s▲%, 180s▲%, △30, the difference 60, △120 are not preferable as the explanatory variable, thus it turns out to which the accuracy becomes bad. The reasons thereof will be described later with reference to Figs. 3C(B) and 3D. Here, among symbols described in the above, the definition of each symbol, which is fearful to bring unclearness, will be described hereinafter.
1) 120s▲%: the decrease rate of the discharge voltage [V] for 120 seconds from any time, (here, removing 10 seconds from start)
2) slope OCV: the whole slope (=dv/dt),
3) 180s▲%: the decrease rate of the discharge voltage [V] for 180 seconds from any time,
4) 30s▲%: the decrease rate of the discharge voltage [V] for 30 seconds from any time, (here, removing 10 seconds from start)
5) △30: the total rate at measurement till 30 seconds from the initial time,
6) △120: the total rate at measurement till 120 seconds from any time,

On the other hand, in the present embodiment, based on the knowledge obtained from accumulation of knowledges and years of experience by the inventor of the present application, it is found that the good accuracy is brought for the remaining battery capacity estimation according to that, for example, the explanatory variable is shown in Fig. 3C(A), the slope OCV is used as x1, the difference 120 (120 seconds difference) is used as x2, 30s▲%(30 seconds decrease rate) is used as x3, through an analysis shown in Fig. 3C mentioned later and Fig. 3D by the Elastic Net method.

That is, describing concretely this, for example, a squared error function (cost function) is used and in Fig. 3C(B), each element was analyzed when a normalization parameter λ positions near 0.01000, to minimize the squared error function. For normalizing the explanatory factor, extracting the partial regression coefficient and selecting elements providing a high impact therefrom, for example, standard partial regression coefficients are calculated from the following relationship formula, to avoid multicollinearity and extract a relative impact, i.e.; $\begin{matrix}Standard partial regression coefficient \left(β\right) \\ = partial regression coefficient \left(β\right) \times standard deviation of independent variable \\ \div standard deviation of the dependent variable .\end{matrix}$

Thereby, if a coefficient with high contribution is selected, the following elements could be extracted.
- No. 11: 30s A % (30 seconds decrease rate)
- No. 20: difference 120 (120 seconds difference)
- No. 25: slope OCV

Here, as shown in the table of Fig. 3D, as for tolerance, the data respectively showing 0.902, 0.776, 0.823 are obtained. Further, as for three explanatory variables, as shown in Fig. 3E, the linearity thereof is confirmed.

Next, for example, as shown in the table of Fig. 3E, each coefficient (partial regression coefficient) k1, k2, k3 of the explanatory variables are calculated. Here, as mentioned before, the partial regression coefficient, further the regression constant can be obtained by using least squares, so that the sum of squares of error of the actual measurements and the predicted values becomes minimum.

### [Concrete method of determination of the partial regression coefficient and the constant]

Next, the method to determine the coefficient k1, k2, k3 of each explanatory variable will be described.

For example, in the present embodiment, the partial regression coefficient (k1~k3) and the regression constant (C) will be described with reference to Fig. 3E. Here, the coefficient value is one example to use in the remaining capacity estimation just in the nickel metal hydride (NiH) battery. According to a kind of the battery to use in the remaining capacity estimation or a meter to measure and the like, it may be a case that these explanatory variables and the coefficient are greatly changed (different).

### (i ) The first partial regression coefficient k1 (coefficient related to the slope indicated in Fig. 3F [slope OCV (the whole slope)

This coefficient k1 is the partial regression coefficient of the first explanatory variable x1. In the present example, the value on the graph in Fig. 3E(C) is approximately read out as an approximate value and roughly estimated. The result is as follows. $\begin{matrix}K 1 = 0.30 - \left(-1.0\right) / 0.04 - \left(-0.11\right) \\ = 8.66 \\ ≒ 8.7\end{matrix}$

Here, in the case of the present example, the actual correct coefficient k1 is calculated on the basis of the exact data. As a result, the value of k1 = 8.731 can be obtained.

### (ii) Second partial regression coefficient k2 (coefficient with the difference D of 120 seconds indicated in Fig. 3G (in this Fig., indicating difference for the state before 30 seconds))

This k2 is the partial regression coefficient of the second explanatory variable x2. In the present example, the value on the graph in Fig. 3E(B) is approximately read out as an approximate value and roughly estimated. The result is as follows. $\begin{matrix}k 2 = - \left[0.80-\left(-0.47\right)\right] / \left[0.01-\left(-0.02\right)\right] \\ = - 1.27 / 0.03 \\ ≒ - 42.3\end{matrix}$

Here, in the case of the present embodiment, the actual correct coefficient k2 is calculated on the basis of the exact data. As a result, a value of k2=-42.449 can be obtained.

### (iii Third regression coefficient k3 (the coefficient of 30s A % decrease rate shown in Fig. 3H)

This coefficient k3 is the partial regression coefficient of the third explanatory variable x3. In the present example, the value on the graph in Fig. 3E(A) is read out as an approximate value and roughly estimated. The result is as follows. $\begin{matrix}k 3 = 1.7 - \left(-1.5\right) / \left[0.002-\left(-0.002\right)\right] \\ = 3.2 / 0.004 \\ ≒ 800\end{matrix}$

Here, in the case of the present embodiment, the actual correct coefficient k3 is calculated on the basis of the exact data. As a result, the value of k3=802.946 can be obtained.

### (iv) Constant (intercept) c

Further, as for the constant (intercept) c, for example, the data described in Fig. 3E is read out and the operation is approximately conducted. As a result, the following is obtained. $y ≒ c + \left(8.7\times 25\right) + \left(-42.5\times 20\right) + \left(803\times 1\right) = 120$

Here, the initial time is set to 3 minutes and if y = 120 is set as to truncate the special time (for example, 120 seconds interval) from the improper time for the remaining capacity estimation,
it is c≒-50.5. Here, in the case of the present example, the actual correct constant (intercept) is calculated on the basis of the exact data. As a result, c=-57.617 is obtained.

Thereby, the regression equation used in the present example can be uniquely determined as shown in the next equation. $y = \left[\left(8.7\right)\cdot \left(x1\right)\right] + \left[\left(-42.5\right)\cdot \left(x2\right)\right] + \left[\left(802.9\right)\cdot \left(x3\right)\right] - 57.6$

Here, y: objective variable
x1 ~ x3: explanatory variable

Here, this regression equation (1)' is adopted for the present example to the end. Thus, needless to say, the remaining battery capacity estimation method of the present invention is, of course, not limited to this equation or coefficients.

Therefore, the correlation of the estimation current capacity and the measured current capacity [Ah] is investigated by using the regression equation (1)' in the present example. As shown in the experimental data of Fig. 3I, as for the predicted value of the residual capacity in the batteries of sample N (= 130), the defect rate by simplified measurement according to the conventional method AC-IR was 34%. However, when an estimation is conducted by using the regression equation (1)', it was found that the defect rate is decreased about 7%.

In addition, according to the present example, the measurement time of the residual capacity is about 2 minutes when the defect rate is decreased about 7% by using the regression equation (1)'. It is found that significant timesaving can be realized in comparison with the conventional case. Here, in the present example, although the remaining capacity is estimated based on the discharge current of the nickel metal hydride (NiH) battery, the remaining capacity in any target battery since in the present invention time-lapse forecasting is conducted through at least any one of the discharge voltage(V) and the discharge current (I) can be estimated.

### [Effect]

As mentioned in the above, in the present example, as shown in Fig. 4, although in the conventional method, it takes about 20 minutes for the discharge voltage measurement to achieve the defect rate 34%, in the present example, the defect rate 7% significantly below 10% obj ective can be realized by the discharge voltage measurement of about 2 minutes. That is, although in the conventional estimation method defect rate is 34%, defect rate can be decreased to 7% according to the estimation method of the present invention, therefore the defect rate can be improved by 27%. Additionally, significant timesaving of the battery quality judgement work to conduct reuse of used batteries, that is, significant time-saving, i.e., from 20 minutes to about 2 minutes, can be achieved, thus waste of time for the quality judgement work can be omitted and an efficiency of quality judgement work can be significantly raised.

In the above, one embodiment and example of the present invention was described. Finally, the description of the embodiment and example is one example of the present invention, and the present invention is not limited to the embodiment and example described in the above. Thus, in another embodiment other than the embodiment and example described in the above, it is of course that various changes depending on the design can be done within a range not deviating the technical concept according to the present invention. Further, although the effect described in the present description is just an example, thus effect is not limited. Further, another effect may be demonstrated.

Here, drawings and data in the embodiment and example described in the above are just one example, are conceptual. Thus, there may be a case that each configuration element creates discrepancies in the present embodiment and the example depending on the battery and also there is a case that configuration elements does not necessarily agree with the battery for an actual use. Further, it is of course that values of data in the drawings significantly differing depending on the battery are included. Further, in a case that estimation method can obtain the effect as the same as the effect described in the embodiment and example, their various effects can be expected.

### REFERENCE of SIGNS

c• • •constant (intercept)
EV• • •explanatory variable (independent variable)
k1• • •whole slope (slope OCV) (= dv/dt) (first explanatory coefficient)
k2• • •difference D (second explanatory variable coefficient)
k3• • •decrease rate (= dv'/dt') (third explanatory variable coefficient)
OV• • •objective variable (or response variable)
OLS• • •least squares
OCV• • •initial voltage or Open Circuit Voltage
P value• • •coefficient
R2• • •precision (amendment value)
T' • • •special time range (=T-t₀)
V• • •charge and discharge voltage
F value• • •significance: statistical significance (that is, significance of regression equation
t value• • •impact
t₀• • •initial time
t_{S}• • •special time
t=0• • •initial time (discharge start time)
T• • •special time range
T' • • •time range
V₀• • •discharge voltage value at initial time
V• • •discharge voltage
V_{S}• • •special value (minimum effective discharge voltage value)

## Claims

1. A remaining-battery-capacity estimation method for estimating a remaining capacity of a battery that is used repeatedly by charging, comprising steps of:
a defining step (S1) for defining a response variable for said remaining-battery-capacity estimation of said battery;
an extraction step (S2) for extracting a plurality of explanatory variables having a high importance and a linearity as an element that is used for said remaining-battery-capacity estimation;
a derivation step (S3) for deriving a relational equation indicating said response variable and said explanatory variables as a regression equation; and
an estimation step (S4) for conducting a time-lapse estimating of at least one of a discharge voltage value and a discharge current value of said battery; and
an estimation step (S5) for estimating the remaining battery capacity,
**characterized in that**
each explanatory variable uses three elements: a decrease slope ([dV/dt] or [dA/dt]) of said discharge voltage value or said discharge current value relative to a whole measuring time, a decrease rate per unit time within a specified time in a range excluding an initial value relative to at least any one of said discharge voltage value and said discharge current value, and a difference corresponding to a decreasing amount per a predetermined time interval.

2. The remaining-battery-capacity estimation method according to claim 1, wherein an initial voltage value is used as a constant (intercept) in said regression equation.

3. The remaining-battery-capacitance estimation method according to claim 1 or 2,
wherein a partial regression coefficient is calculated by normalizing said each explanatory variable, and
said partial regression coefficient is used as said each coefficient in each purpose variable in said regression equation.

4. The remaining-battery-capacity estimation method according to one of claims 1 to 3,
wherein said regression equation includes any one of an initial voltage value and an initial current value as a constant term in addition to said plural explanatory variables.

## Patentansprüche

1. Restbatteriekapazität-Schätzverfahren zum Schätzen einer Restkapazität einer Batterie, die wiederholt durch Laden verwendet wird, umfassend die folgenden Schritte:
einen Definitionsschritt (S1) zum Definieren einer Antwortvariablen für die Restbatteriekapazität-Schätzung der Batterie;
einen Extraktionsschritt (S2) zum Extrahieren einer Vielzahl von erklärenden Variablen, die eine hoher Wichtigkeit und Linearität als Element aufweisen, das für die Restbatteriekapazität-Schätzung verwendet wird;
einen Ableitungsschritt (S3) zum Ableiten einer Beziehungsgleichung, die die Antwortvariable und die erklärenden Variablen als Regressionsgleichung angibt;
und einen Schätzschritt (S4) zum Durchführen einer Zeitreihenschätzung von mindestens einem von der Entlade-Spannungswerte und Entlade-Stromwerte der Batterie;
und einen Schätzschritt (S5) zum Schätzen der Restbatteriekapazität, **dadurch gekennzeichnet, dass** jede erklärende Variable drei Elemente verwendet: eine Abnahmesteigung ([dV/dt] oder [dA/dt]) des Entlade-Spannungswerts oder des Entlade-Stromwerts in Bezug auf die gesamte Messzeit, eine Abnahmerate pro Zeiteinheit innerhalb einer spezifizierten Zeit in einem Bereich, der einen Anfangswert ausschließt, in Bezug auf zumindest einen von dem Entlade-Spannungswert und dem Entlade-Stromwert, und eine Differenz, die einer Abnahmemenge pro vorbestimmten Zeitintervall entspricht.

2. Restbatteriekapazität-Schätzverfahren nach Anspruch 1, wobei ein Anfangsspannungswert als Konstante (Achsenabschnitt) in der Regressionsgleichung verwendet wird.

3. Restbatteriekapazität-Schätzverfahren nach Anspruch 1 oder 2,
wobei ein partieller Regressionskoeffizient durch Normierung jeder erklärenden Variablen berechnet wird und
der genannte partielle Regressionskoeffizient als jeweiliger Koeffizient in jeder Zielvariablen in der Regressionsgleichung verwendet wird.

4. Restbatteriekapazität-Schätzverfahren nach einem der Ansprüche 1 bis 3,
wobei die Regressionsgleichung einen Anfangsspannungswert oder einen Anfangsstromwert als Konstanten zusätzlich zu der Vielzahl von erklärenden Variablen beinhaltet.

## Revendications

1. Procédé d'estimation de capacité de batterie restante pour estimer une capacité restante d'une batterie qui est utilisée de manière répétée par chargement, comprenant les étapes suivantes :
une étape de définition (S1) pour définir une variable de réponse pour ladite estimation de capacité de batterie restante de ladite batterie ;
une étape d'extraction (S2) pour extraire une pluralité de variables explicatives ayant une grande importance et une linéarité en tant qu'élément utilisé pour ladite estimation de capacité de batterie restante ;
une étape de dérivation (S3) pour dériver une équation relationnelle indiquant ladite variable de réponse et lesdites variables explicatives sous forme d'équation de régression ;
une étape d'estimation (S4) pour effectuer une estimation accélérée d'au moins l'une d'une valeur de tension de décharge et d'une valeur de courant de décharge de ladite batterie ; et
une étape d'estimation (S5) pour estimer la capacité de batterie restante,
**caractérisé en ce que** chaque variable explicative utilise trois éléments : une pente décroissante ([dV/dt] ou [dA/dt]) de ladite valeur de tension de décharge ou de ladite valeur de courant de décharge par rapport à l'ensemble du temps de mesure, un taux de diminution par unité de temps dans un temps spécifié dans une plage excluant une valeur initiale par rapport à au moins l'une quelconque de ladite valeur de tension de décharge et de ladite valeur de courant de décharge, et une différence correspondant à une quantité de diminution par intervalle de temps prédéterminé.

2. Procédé d'estimation de capacité de batterie restante selon la revendication 1, dans lequel une valeur de tension initiale est utilisée comme constante (ordonnée à l'origine) dans ladite équation de régression.

3. Procédé d'estimation de capacité de batterie restante selon la revendication 1 ou 2,
dans lequel un coefficient de régression partielle est calculé en normalisant ladite chaque variable explicative, et
ledit coefficient de régression partielle est utilisé en tant que ledit chaque coefficient dans chaque variable de but dans ladite équation de régression.

4. Procédé d'estimation de capacité de batterie restante selon l'une des revendications 1 à 3,
dans lequel ladite équation de régression comprend l'une quelconque d'une valeur de tension initiale et d'une valeur de courant initial en tant que terme constant en plus desdites multiples variables explicatives.
